# EUROPEAN PATENT APPLICATION

(11) **EP 0 901 234 A2**
(43) Date of publication of application: **10.03.1999**
(21) Application number: 98306986.5
(22) Date of filing: 01.09.1998
(51) Int. Cl.: H03M 13/00

(54) **Viterbi compare-select operation for two-bit traceback coding**

(30) Priority: 08.09.1997 US 925517
(71) Applicant: LUCENT TECHNOLOGIES INC., Murray Hill, New Jersey 07974-0636 (US)
(72) Inventor: Mobin, Moahmmad Shafiul, Whitehall, Pennsylvania 18052 (US); Tate, Larry R., South Barrington, Illinois 60010 (US); Simanapalli, Sivanand, Allentown, Pennsylvania 18104 (US)
(74) Representative: Watts, Christopher Malcolm Kelway, Dr.

(57) **Abstract**

There is disclosed a technique of operating a digital communication system includes generating first, second, third and fourth metrics. A first intermediate extremum is selected from the first and second metrics. A second intermediate extremum is selected from the third and fourth metrics. An extremum is selected from the first and second intermediate extrema. A pair of traceback bits corresponding to the surviving branch is generated and may be stored.

## Description

### Technical Field

This invention relates generally to viterbi decoding and particularly to a compare-select operation for two-bit traceback coding.

### Background of the Invention

A viterbi decoder is a maximum likelihood decoder that provides forward error correction. Viterbi decoding is used in decoding a sequence of encoded symbols, such as a bit stream. The bit stream can represent encoded information in a system that is transmitted through various media with each set of bits representing a symbol instant. Viterbi decoding is employed in digital communications over any communication channel, such as satellite-to-earth, cellular telephony, computer-to-disk, modem-to-modem and others. Viterbi decoders have been implemented on hardware microprocessors, microcontrollers, or digital signal processors. Viterbi decoding is well known and applications can be found in U.S. Patents 5,490,178; 5,454,014; 5,559,837; 5,465,275; and 5,471,500.

A viterbi implementation consists of four steps: (1) branch and path metric computation; (2) a compare-select operation; (3) a minimum or maximum state cost determination ; and (4) a traceback operation. In the decoding process, a viterbi decoder works back through a sequence of possible bit sequences at each symbol instant to determine which one-bit sequence was most likely to have been transmitted. The possible transitions from a state at one symbol instant, or present state, to a state at a next, subsequent symbol instant, or next state, is limited. Each possible transition from a present state to a next state can be shown graphically and is defined as a branch. A sequence of interconnected branches is defined as a path. Each state can only transition to a limited number of next states upon receipt of the next bit or bits in the bit stream. Thus, some branches survive to become part of a path and other branches do not survive to become part of a path. By eliminating those transitions or branches that are not permissible, computational efficiency can be achieved in determining the most likely paths to survive. The viterbi decoder typically defines and calculates a branch metric associated with each branch and employs the branch metric to determine which paths survive and which paths do not survive.

A branch metric is calculated at each symbol instant for each possible branch. Each path has an associated metric or accumulated cost that is updated at each symbol instant. For each possible transition, the accumulated cost for the next state is calculated as a sum of a branch metric and the path accumulated cost at the present state origin of the branch metric. A maximum or minimum extremum may be selected.

While several branches, and hence several paths, survive the transition from one symbol instant to the next symbol instant, a traceback operation through the surviving paths is employed to select the most likely bit or bit sequence to have been transmitted. The sequential symbol instants may be represented in an array referred to as a trellis. Identifying the extremum accumulated cost path starting with a given symbol instant is referred to as a traceback operation. The number of symbol instants back through the trellis that the extremum accumulated cost path extends is the length, or depth, of the traceback operation. At the end of the traceback operation, the individual state in the trellis associated with the surviving path that originated at an extremum accumulated cost is translated into the most likely bit or bits to have been transmitted in that symbol instant. The bit or group of bits is referred to as a decoded symbol.

In viterbi decoding applications in which a single bit is transmitted each symbol instant, two possible present states can transition, or branch, into a single next state and a single bit is sufficient to uniquely determine which of the two possible branches transitioned into a given next state. Viterbi decoding applications in which two bits are transmitted each symbol instant four possible present states that can transition into a single next state. With four present states possible to transition into a single next state, two bits are necessary to uniquely determine which of the four possible branches transitioned into a given next state. Applications in which two bits are transmitted each symbol instant include but are not limited to v.34 modem technology, as well as time-division, multiple-access (TDMA) standards IS-54 and IS-136.

What is needed is an efficient method for comparing four metrics and selecting the extremum metric, along with generating and storing a pair of traceback bits to uniquely identify the surviving branch that transitioned from a present state to a next state.

### Summary of the Invention

In accordance with the invention, a technique of operating a digital communication system includes generating first, second, third and fourth metrics. A first intermediate extremum is selected from two of the metrics. A second intermediate extremum is selected from the other two of the metrics. An extremum is selected from the first and second intermediate extrema. A pair of traceback bits corresponding to the surviving branch is generated and stored.

### Brief Description of the Drawings

Figure 1 is a schematic diagram of a portion of a data arithmetic unit in accordance with the present invention;
Figure 2 is a portion of a present-state, next-state diagram illustrating a 16-state example viterbi butterfly in which four possible present states can transition into a single next state; and
Figure 3 is a more detailed portion of the data arithmetic unit of Figure 1.

### Detailed Description

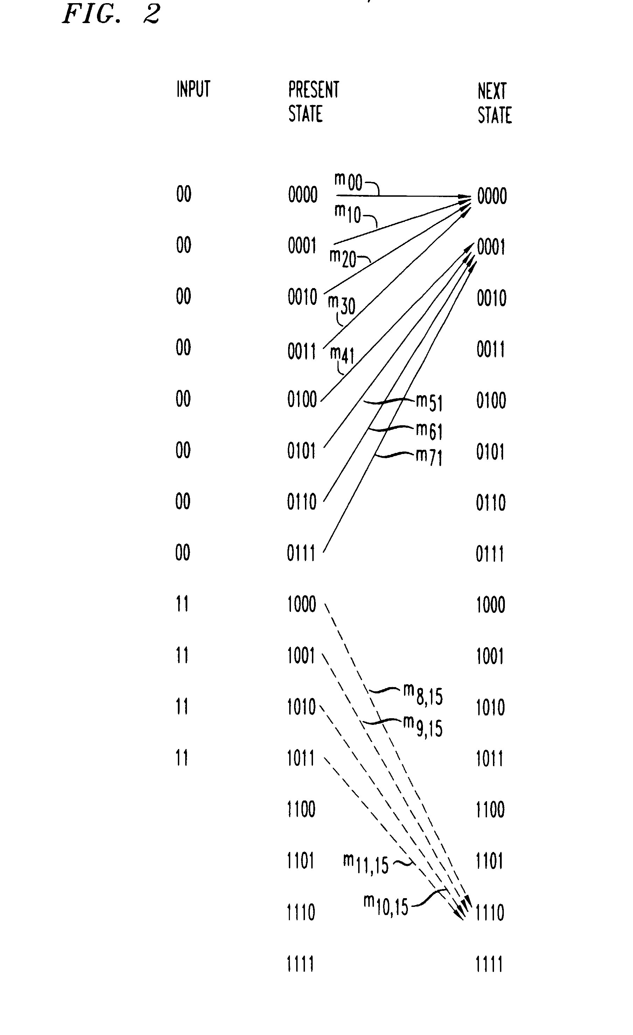

A portion of a present-state, next-state diagram illustrating a viterbi butterfly in a 16-state example in which four possible present states can transition into a given next state is illustrated in Figure 2. With a right shifting of a two-bit input 00, any of the first four present states S₀ :0000, S₁:0001, S₂:0010, and S₃ :0011 will transition into next state NS₀ :0000 as the last two bits of the present state are shifted out. While not all of the possible transitions have been illustrated, each of the 16 next states has, upon receipt of all combinations of two-bit inputs, four possible present states that can transition to each of the next states. Stated differently, each of the 16 next states can have four present states transition to it upon receipt of all combinations of two-bit inputs. Thus, for a 16 state example, as shown in Figure 2, there are 64 possible branch transitions from present states to next states. Twelve of the possible 64 branches are illustrated.

Each of the branches has an associated branch metric designated mᵢⱼ, where i represents the present state and j represents the next state at respective ends of the branch. Each of the present states has an accumulated cost, PSᵢ associated with the i^{th} present state, i =0,1,2,... 15. Accumulated cost PSᵢ is the sum of the branch metrics associated with surviving branches of all branches in a path up to the present state. The accumulated cost metric for a next state NSⱼ is the sum of the present state accumulated cost PSᵢ associated with the i^{th} present state, and one of the branch metrics mᵢⱼ, which may be, for example, based on a Euclidean or Hamming, sometimes known as Manhattan, distance.

The four branch metrics mᵢⱼ, that terminate in a given next state, such as next state 0000, are computed and added to the present state accumulated cost to produce four potential next state costs which are compared. An extremum potential next state cost (either a maximum or minimum) is selected in the comparison operation as a next state cost associated with the next state at which the extremum potential next state cost metric terminates. The present state-to-next state transition associated with the extremum metric is a branch in a surviving path. The extremum metric is a next state cost associated with the next state at the end of the surviving branch. The two-bits from the present state that would be shifted out are stored as traceback bits to be used in reconstructing a traceback path of surviving branches. Similar computations with respect to all of the present states results in an update of accumulated costs for all of the next states and storage of two traceback bits associated with each next state. Thus, when metric m₀₀ comprises part of the extremum, 00 is stored as a two-bit traceback pair of bits; when m₁₀ comprises part of the extremum, 01 is stored as a two-bit traceback pair of bits; when m₂₀ comprises part of the extremum, 10 is stored as a two-bit traceback pair of bits; and when m₃₀ comprises part of the extremum, 11 is stored as a two-bit traceback pair of bits.

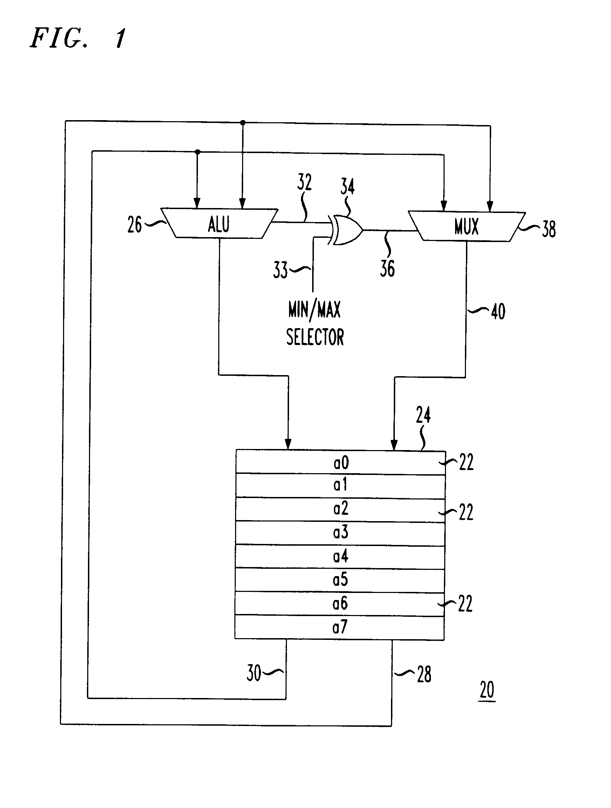

The four branch metrics associated with a given next state are computed and added to the respective present state cost associated with the origin of the branch metric to generate four potential next state costs PNS₀₀, PNS₀₁, PNS₀₂, and PNS₀₃. The four potential next state cost metrics are systematically compared in a data arithmetic unit 20 shown in Figure 1 such as in a microprocessor, microcontroller or digital signal processor, to select an extremum of the four potential next state costs. Metrics PNS₀₀, PNS₀₁, PNS₀₂, and PNS₀₃ are computed, as is known in the art, and stored in four registers 22 of register file 24, illustrated as registers a0, a1, a2 and a3, respectively.

Metric PNS₀₀ from register a0 is provided as a first input to arithmetic logic unit (ALU) 26 over line 28 and metric PNS₀₁ from register al is provided as a second input to ALU 26 over line 30. ALU 26 compares the two inputs, such as by computing the difference. The ALU sign flag of the difference is provided over line 32 as a first input to exclusive OR gate 34. The second input to exclusive OR gate 34 is a one bit input selector 33 that takes on one of a first and second state to select either the lesser or greater of the two inputs being compared in the ALU. Selecting the lesser input to ALU 26 corresponds to selecting the minimum metric and selecting the greater input to ALU 26 corresponds to selecting the maximum metric. Depending on the manner in which numbers are represented, a min/max selector of a first state such as a logical one may select the lesser input whereas a min/max selector of a second state such as a logical zero may select the greater input to the ALU. The output of exclusive OR gate 34 is provided as a select input 36 to multiplexer 38. Multiplexer 38, which receives the same inputs as ALU 26, selects one of the two metrics PNS₀₀ or PNS₀₁ as the first intermediate extrema and stores the selected first intermediate extrema in register a0. In this manner, the first and second metrics are compared to each other and a first intermediate extremum metric is selected.

Similarly, metric PNS₀₂ from register a2 is provided as a first input to ALU 26 over line 28 and metric PNS₀₃ from register a3 is provided as a second input to ALU 26 over line 30. ALU 26 compares the two inputs, such as by computing the difference. Multiplexer 38 selects one of the two metrics PNS₀₂ or PNS₀₃ as the second intermediate extrema and provides the second intermediate extrema to register file 24 over line 40 where it is stored in register a2. In this manner, the third and fourth metrics are compared to each other and a second intermediate extremum metric is selected.

The first intermediate extremum from register a0 is provided as a first input to ALU 26 over line 28 and the second intermediate extremum from register a2 is provided as a second input to ALU 26 over line 30. ALU 26 compares the two intermediate extrema, such as by computing the difference. The ALU sign flag is provided over line 32 as an input to exclusive OR gate 34. With min/max selector in the same state as above, the output from exclusive OR gate 34 is provided as a select input to multiplexer 38. Multiplexer 38 selects one of the first and second intermediate extrema as the extremum and provides the extremum to register file 24 over line 40 where it is stored in register a0. In this manner, the first and second intermediate extrema are compared and an extremum selected.

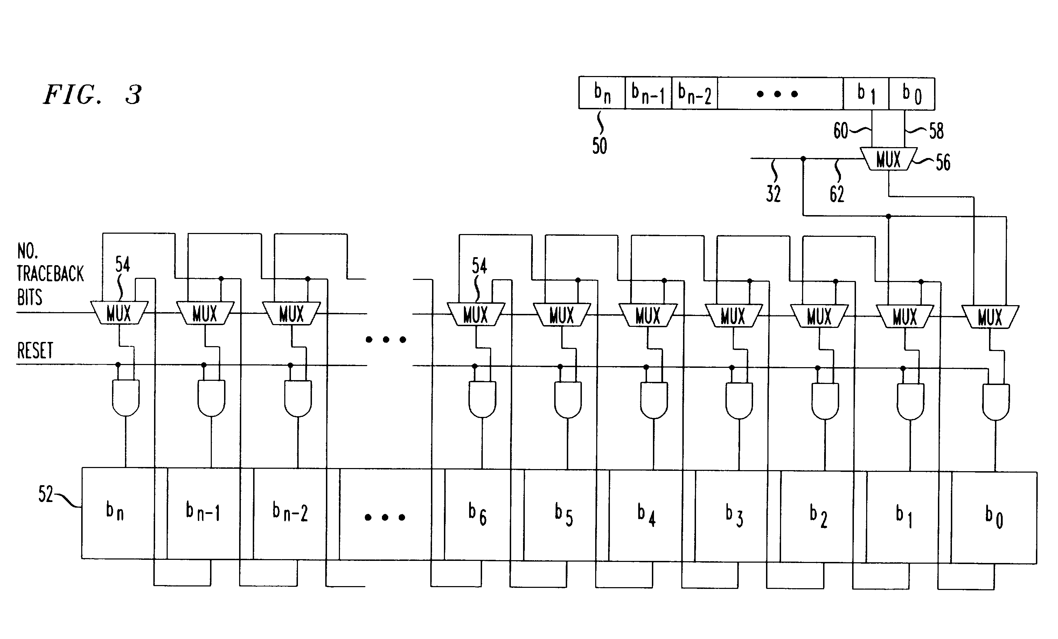

A two-bit traceback pair of bits is constructed as the intermediate extrema are compared and an extremum selected. A circuit to construct and store the two-bit traceback pair is shown in Figure 3.

When the first and second potential next state cost metrics are compared in ALU 26, the least significant bit (LSB) of the present state of the origin of the branches associated with the first and second potential next state cost metrics differ. The LSB uniquely determines the present state origin of the first intermediate extrema. The LSB is a first potential first bit position traceback bit and is stored in the LSB of a multibit register 50 shown in Figure 3. In this manner, a corresponding first potential first bit position traceback bit is selected to identify which of the two potential next state cost metrics is selected as the first intermediate extremum.

When third and fourth potential next state cost metrics are compared in ALU 26, the LSB of the present state of the origin of the branches associated with the third and fourth potential next state cost metrics differ. The LSB of the present state of the origin of the branches associated with the third and fourth potential next state cost metrics again uniquely determines the present state origin of the second intermediate extrema. The LSB is a second potential first bit position traceback bit and is stored in the LSB of register 50 with the previously stored LSB shifted to the second bit position of register 50. In this manner, a corresponding second potential first bit position traceback bit is selected to identify which of the two potential next state cost metrics was selected as the second intermediate extremum.

When the first and second intermediate extrema are compared in ALU 26, the bit adjacent the LSB of the present state (the second bit of the present state) of the origin of the branches associated with the first and second intermediate extrema differ. The second bit of the present state can uniquely determine whether the intermediate extrema selected as the extremum is selected from the first and second potential next state cost metrics or from the third and fourth potential next state cost metrics. This bit, referred to in constructing the two-bit traceback pair as the second bit position traceback bit, is provided to the second bit of register 52. In this manner, a corresponding second bit position traceback bit is selected to identify which of the two intermediate extrema was selected as the extremum. The second bit position traceback bit is provided as the most significant bit of the traceback bit pair as explained below.

Register 52 is a multibit shift register for storing a plurality of traceback bits. With the select input to multiplexers 54 set to a first logical state such as a zero, a single traceback bit will be stored in the LSB of register 52. Each occurrence of generating a new traceback bit will cause shift register 52 to shift previously stored bits one position (to the left in Figure 3) and store the new traceback bit in the LSB. This one-bit traceback mode of operation is useful when there are two possible transitions from a present state to a next state. When sufficient register locations are filled, as determined by a user, the traceback bits in shift register 52 may be written to storage as is known in the art.

With the select input to multiplexers 54 set to a second logical state such as one, a pair of traceback bits will be stored in the two least significant bits of shift register 52. Each two-bit traceback pair is stored initially in the two least significant bits of shift register 52. With the generation of another two-bit traceback pair, the existing two-bit traceback pair, along with other previously stored two-bit traceback pairs, is shifted left two registers in shift register 52 and the most recent two-bit traceback pair is stored in the two least significant bit locations of shift register 52. This two-bit traceback mode of operation is useful when there are four possible transitions from a present state to a next state. When sufficient register locations are filled, the traceback bit pairs in shift register 52 may be written to storage.

Multiplexer 56 has a first input 58 coupled to the LSB of register 50, a second input 60 coupled to the second bit position register of register 50, and a select input 62 coupled to line 32 to receive the ALU sign flag. When operating in the one-bit traceback mode, the ALU sign flag generated when an extremum is selected is provided as an input to the LSB of shift register 52. When operating in the two-bit traceback mode, multiplexer 56 selects the bit stored in either the LSB register or a second bit position register of register 50 as the LSB of a two-bit traceback pair and provides the ALU sign flag generated as the extremum is selected, that is during comparison of the first and second intermediate extrema, as the more significant bit of the two-bit traceback pair. The more significant bit of the two-bit traceback pair is stored in the second bit position register of shift register 52.

When the intermediate extrema selected as the extremum is selected from the first and second potential next state cost metrics, the least significant bit of the two-bit traceback pair is selected as the first potential first bit position traceback bit which is temporarily stored in the second bit position register of register 50. When the intermediate extrema selected as the extremum is selected from the third and fourth potential next state cost metrics, the least significant bit of the two-bit traceback pair is the second potential first bit position traceback which is temporarily stored in the least significant bit position of register 50. The bits stored in register 50 are overwritten in subsequent comparison operations.

While the invention has been described as comparing four potential next state costs, the invention is not limited thereto. Four branch metrics could be compared in accordance with the invention and an extremum branch metric selected. The extremum branch metric would be summed with the accumulated cost associated with the present state at the origin of the extremum branch metric to provide a next state cost associated with the next state at the termination of the extremum branch metric. Traceback bits, generated and stored as described above, would indicate which of the four branch metrics is selected as the extremum branch metric.

While packing the traceback bits has been described as placing the most recent traceback bit or bits in the least significant bit or bits location, one skilled in the art could provide a design that places the most recent traceback bit or bits in the most significant registers.

While the illustrative embodiment has not been described as incorporating pipelining, one skilled in the art would recognize the enhanced computational efficiency available by utilizing pipelining in the design. Pipelining is achieved by initiating computation with a new data set before completing computations with a previous data set. The more latches used in pipelining the greater the depth of pipelining. Pipelining causes an initial latency in computation time required to fill the pipeline, but maximizes uses of resources such as adders.

## Claims

1. A method of operating a digital communication system, comprising the steps of:
generating first (PSN₀₀), second (PSN₀₁), third (PSN₀₂) and fourth (PSN₀₃) metrics;
selecting a first intermediate extremum from the first (PSN₀₀) and second (PSN₀₁) metrics;
selecting a second intermediate extremum from the third (PSN₀₂) and fourth (PSN₀₃) metrics; and
selecting an extremum from the first and second intermediate extrema.

2. A method of operating a digital communication system as recited in claim 1, further comprising the steps of:
generating a first potential first bit position traceback bit corresponding to which of the first and second metrics (PSN₀₀,PSN₀₁ ) is selected as the first intermediate extremum metric;
generating a second potential first bit position traceback bit corresponding to which of the third and fourth (PSN₀₂,PSN₀₃) metrics is selected as the second intermediate extremum metric; and
generating a second bit position traceback bit corresponding to which of the first and second intermediate extrema metrics is selected as the extremum.

3. A method of operating a digital communication system as recited in claim 1 or 2, further comprising the step of storing traceback bits to indicate which of the first (PSN₀₀), second (PSN₀₁), third (PSN₀₃) and fourth (PSN₀₄) metrics is selected as the extremum.

4. A method of operating a digital communication system as recited in claim 3, wherein the step of storing traceback bits comprises:
storing intermediate bits indicating selection of intermediate extrema; and
constructing the traceback bits from a bit generated during selection of intermediate extrema and a bit associated with selection of the extremum from intermediate extrema.

5. A method of operating a digital communication system as recited in claim 2, further comprising the step of selecting one of the first potential least-significant-bit traceback bit and the second potential least-significant-bit traceback bit as the least significant traceback bit based on which of the first and second intermediate extrema metrics is selected as the extremum metric.

6. A method of operating a digital communication system as recited in claim 2, wherein the step of generating a first potential first bit position traceback bit comprises generating a least-significant-bit traceback bit.

7. A method of operating a digital communication system as recited in claim 2, wherein the step of generating a second bit position traceback bit comprises generating a most-significant-bit traceback bit.

8. A method of operating a digital communication system as recited in claim 1 or 6, wherein the step of selecting a first intermediate extremum comprises comparing the first and second metrics.

9. A method of operating a digital communication system as recited in any of claims 1 through 8, wherein the step of selecting a first intermediate extremum comprises selecting the larger of the first and second metrics.

10. A method of operating a digital communication system as recited in any of claims 1 through 8, wherein the step of selecting a first intermediate extremum comprises selecting the smaller of the first (PSN₀₀) and second (PSN₀₁) metrics.

11. A method of operating a digital communication system as recited in any of claims 1 through 8, wherein the selecting steps select the larger of the first (PSN₀₀) and second (PSN₀₁) metrics as the first intermediate extremum, the larger of the third (PSN₀₂) and fourth (PSN₀₃) metrics as the second intermediate extremum, and the larger of the first and second intermediate extrema as the extremum.

12. A method of operating a digital communication system as recited in claim 1 through 8, wherein the selecting steps select the smaller of the first and second metrics as the first intermediate extremum, the smaller of the third and fourth metrics as the second intermediate extremum, and the smaller of the first and second intermediate extrema as the extremum.

13. A method of operating a digital communication system as recited in any of claims 1 through 12, wherein the metrics are potential next state costs.

14. A method of operating a digital communication system as recited in any of claims 1 through 12, wherein the metrics are branch metrics.

15. An integrated circuit for decoding encoded data, comprising:
circuitry adapted to generate and store first, second, third and fourth metrics;
an arithmetic logic unit (26) adapted to compare the first and second (PSN₀₀,PSN₀₁) metrics and to select a first intermediate extremum therefrom, the arithmetic unit (26) adapted to compare the third and fourth (PSN₀₂,PSN₀₃) metrics and to select a second intermediate extremum therefrom, the arithmetic unit adapted to compare the first and second intermediate extrema and to select therefrom an extremum.

16. An integrated circuit as recited in claim 15, further comprising a register (52) for storing a traceback bit corresponding to which of the first and second metrics is selected.

17. An integrated circuit as recited in claim 16, wherein the register (52) is a shift register.

18. An integrated circuit as recited in claim 17, wherein the shift register (52) is shiftable by a selectable number of memory locations.
